# FASCICULE DE BREVET EUROPEEN

(11) **EP 3 900 043 B1**
(45) Date de publication et mention de la délivrance du brevet: **25.01.2023**
(21) Numéro de dépôt: 19832684.5
(22) Date de dépôt: 20.12.2019
(51) Int. Cl.: H01L 27/22, H01L 43/12

(54) **PROCEDE DE FABRICATION D'UN DISPOSITIF SPINTRONIQUE COMPORTANT UNE COUCHE MAGNETIQUE ACTIVE EPAISSE**
VERFAHREN ZUR HERSTELLUNG EINER SPINTRONIC-VORRICHTUNG MIT EINER DICKEN AKTIVEN MAGNETISCHEN SCHICHT
PROCESS FOR FABRICATING A SPINTRONIC DEVICE INCLUDING A THICK ACTIVE MAGNETIC LAYER

(30) Priorité: 21.12.2018 FR 1873730
(43) Date de publication de la demande: 27.10.2021
(73) Titulaire: Commissariat à l'Energie Atomique et aux Energies Alternatives, 75015 Paris (FR); Centre National de la Recherche Scientifique - CNRS, 75794 Paris Cedex 16 (FR)
(72) Inventeur: DIENY, Bernard, 38054 Grenoble Cedex 09 (FR); PREJBEANU, Ioan-lucian, 38054 Grenoble Cedex 09 (FR)
(74) Mandataire: Cabinet Camus Lebkiri
(86) Numéro de dépôt international: PCT/EP2019/086677
(87) Numéro de publication internationale: WO 2020/127970

(56) Documents cités:
- FR-B1- 3 027 453
- US-A1- 2013 015 540
- US-A1- 2013 029 431
- US-A1- 2015 194 595
- US-A1- 2015 236 251
- US-A1- 2016 218 280

## Description

### DOMAINE TECHNIQUE DE L'INVENTION

Le domaine technique de l'invention est celui de la spintronique. La présente invention concerne un procédé de fabrication de dispositifs spintroniques comprenant une couche magnétique épaisse et en particulier la fabrication de mémoires magnétiques à accès aléatoire (MRAM selon la dénomination anglo-saxonne « Magnetic Random-Access Memory ») à couple de transfert de spin (STT selon la dénomination anglo-saxonne « Spin-Transfer Torque ») ou couple de spin orbite (SOT selon la dénomination anglo-saxonne « Spin Orbit Torque »), de capteurs de champs magnétiques et de composants radiofréquence utilisant le couple de transfert de spin (STT) ou le couple de spin orbite (SOT).

### ARRIERE-PLAN TECHNOLOGIQUE DE L'INVENTION

Les mémoires les plus couramment utilisées comme mémoire de travail, les DRAM (selon la dénomination anglo-saxonne « Dynamic Random Access memory ») et les SRAM (« Static Random Access Memory ») sont volatiles, c'est-à-dire qu'elles doivent être continuellement alimentées en tension pour conserver l'information. Ces mémoires ont de plus en plus de problèmes de consommation d'énergie, notamment en mode statique, en raison d'un courant de fuite accru dû à leur diminution en taille.

Une alternative à ces mémoires est la mémoire FLASH qui est non volatile. Mais un inconvénient majeur de son utilisation est son endurance à l'écriture limitée à au plus 100 000 cycles.

Ainsi, d'autres types de mémoire non volatile sont développés, avec des degrés de maturité divers, notamment les mémoires à changement de phase PCRAM (« Phase Change Random Access Memory »), les mémoires résistives à pont conducteur CBRAM (« Conductive Bridge RAM ») ou bien à base d'oxyde OxRAM, les mémoires ferroélectriques FeRAM et les mémoires magnétiques MRAM. Hormis les mémoires FeRAM qui fonctionnent selon le principe de l'orientation d'un moment dipolaire électrique dans un matériau ferroélectrique, toutes les autres mémoires utilisent des matériaux de résistance électrique variable. Chaque bit d'information est stocké dans un élément de résistance variable et codé par la valeur de résistance de cet élément de stockage (typiquement le niveau logique '0' correspond à une forte valeur de résistance et le niveau logique '1' correspond à une faible valeur de résistance).

Dans les MRAM en particulier, l'élément de stockage est une jonction tunnel magnétique présentant un effet de magnétorésistance tunnel. Ecrire dans une mémoire MRAM revient à orienter l'aimantation d'une des électrodes magnétiques de la jonction tunnel (électrode appelée couche de stockage) parallèlement ou antiparallèlement à l'aimantation de la deuxième électrode d'aimantation fixe appelée couche de référence.

Dans la première famille de MRAMs, l'écriture était faite par pulses de champs magnétiques. Des produits commerciaux de la société EVERSPIN^{™} appelés Toggle MRAM ont utilisé ce procédé d'écriture à partir de 2006. Cependant, la densité de ces mémoires est limitée à quelques Mbit car le courant nécessaire pour produire les pulses de champs magnétiques (-10mA), ne permet pas de descendre à des noeuds technologiques inférieurs à 90nm.

La deuxième famille de MRAM qui retient aujourd'hui le plus d'attention est la famille des MRAMs écrites par transfert de spin (« spin transfer torque », STT). Il s'agit des STT-MRAM. Le phénomène de transfert de spin a été prédit en 1996 par Sionczewski (Slonczewski, J. C., 1996, "Current driven excitations of magnetic multilayers," J. Magn. Magn. Mater.159, L1-L7) et Berger (Berger, L., 1996, "Emission of spin waves by a magnetic multilayer traversed by a current", Phys. Rev. B 54, 4828-4830) et la possibilité d'utiliser ce phénomène pour faire commuter l'aimantation de couches magnétiques a été démontré expérimentalement pour la première fois en 2000 (Katine, J.A., F. J. Albert, R. A. Buhrman, E. B. Myers, and D. C. Ralph, 2000, "Current-driven magnetization reversai and spin-wave excitations in Co /Cu /Co pillars," Phys. Rev. Lett.84, 3149-3152).

L'utilisation du transfert de spin (STT selon la dénomination aglo-saxonne « spin transfer torque ») pour écrire dans une jonction tunnel magnétique fournit une meilleure configuration, en particulier lorsque la densité est importante, c'est-à-dire lorsque la mémoire est de petite taille (typiquement inférieure à 50 nm de diamètre).

Les STT-MRAM de l'état de l'art utilisent des jonctions tunnels magnétiques à anisotropie perpendiculaire comme éléments de stockage. Dans ces jonctions tunnel magnétiques, l'anisotropie magnétique provient de phénomènes d'hybridation électronique se produisant à l'interface métal magnétique/oxyde, l'oxyde étant le matériau formant la barrière tunnel de la jonction, le plus souvent du MgO.

Pour fabriquer ces jonctions tunnel magnétiques utilisées dans les mémoires non volatiles ou dans d'autres composants spintroniques (des unités logique magnétiques « MLU », ou des capteurs de champs magnétique par exemple), le document FR3027453B1 (B. DIENY ET AL. [FR]) propose un procédé de fabrication d'un dispositif résistif pour circuit mémoire ou logique.

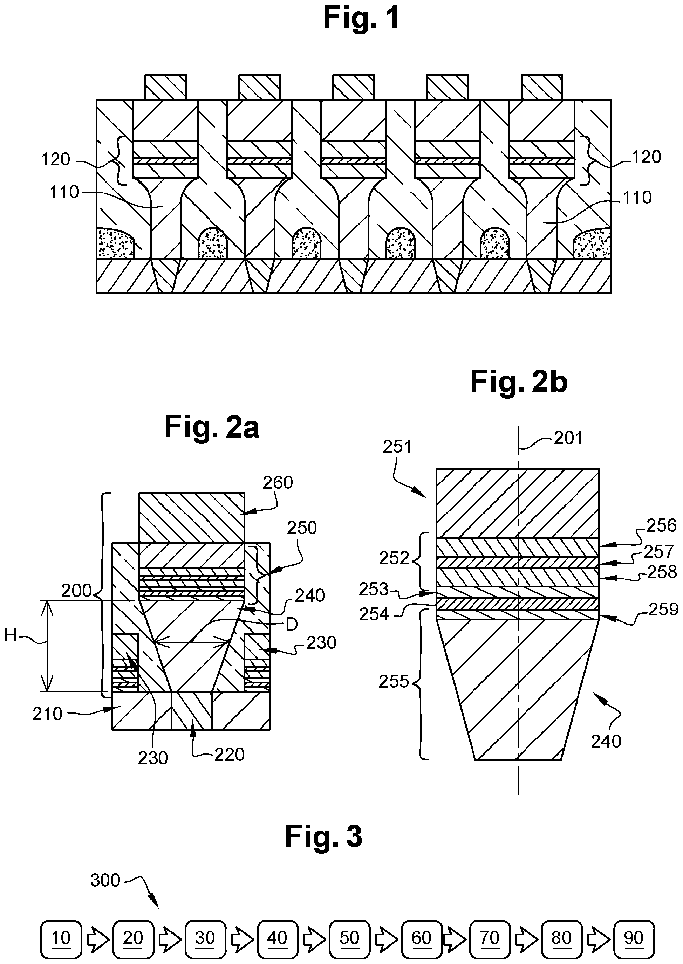

[Fig. 1] représente ce dispositif. Il décrit une méthode de nanostructuration de jonctions tunnel magnétiques 120 permettant d'éviter la gravure de l'empilement magnétique (en particulier de jonctions tunnel magnétiques). Le procédé de fabrication selon ce document consiste à déposer cet empilement 120 sur un pilier métallique 110 prégravé ou un réseau de tels piliers. Au cours du dépôt de l'empilement par une méthode de dépôt en phase physique (par exemple la pulvérisation cathodique), le matériau se nanostructure naturellement en se déposant sur le sommet des piliers prégravés. Dans le cas de la réalisation de cellules mémoires de type MRAM (selon la dénomination anglo-saxonne « Magnetic Random Access Memory ») à base de jonction tunnel magnétique, les points mémoire sont formés par les dépôts réalisés au sommet de chacun des piliers.

Cependant, ce procédé de fabrication se limite au cas où la couche de stockage de la jonction tunnel magnétique est fine. Dans ce cas, l'anisotropie perpendiculaire interfaciale à l'interface entre la couche de stockage et la barrière tunnel est partiellement contrebalancée par l'anisotropie de forme de la couche de stockage qui favorise une anisotropie planaire. De ce, fait l'anisotropie effective est réduite. Même en utilisant une couche de stockage insérée entre deux barrières tunnel, l'anisotropie effective n'est pas suffisante pour assurer une rétention de la mémoire suffisamment longue lorsque la dimension des jonctions tunnel devient inférieure à une trentaine de nanomètres (typiquement une dizaine d'années selon les exigences industrielles). Par ailleurs cette anisotropie varie fortement en fonction de la température (typiquement d'au moins 40% sur 100°C), ce qui est gênant pour un fonctionnement de la mémoire sur une large gamme de températures (comme par exemple pour les applications automobile devant fonctionner entre -40°C et +150°C).

Récemment, K. Watanabe et al. (K. Watanabe, B. Jinnai, S. Fukami, H. Sato & H. Ohno, « Shape anisotropy revisited in single-digit nanometer magnetic tunnel junctions », 14 February 2018, Nature Communications 9, Article number: 663) ainsi que N.Perrissin et al. (N. Perrissin, S. Lequeux, N. Strelkov, L. Vila, L. Buda-Prejbeanu, S. Auffret, R.C. Sousa, I.L. Prejbeanu, B. Dieny, « Highly thermally stable sub-20nm magnetic random-access memory based on perpendicular shape anisotropy », Nanoscale, 2018, 10, 12187-12195, DOI : 10.1039/C8NR01365A) ont proposé une jonction tunnel magnétique pour cellule mémoire dans laquelle l'épaisseur de la couche de stockage a été très significativement augmentée à des valeurs de même ordre de grandeur que leur diamètre pour permettre de bénéficier d'une anisotropie de forme hors du plan (PSA, selon la dénomination anglo-saxonne « Perpendicular Shape Anisotropy »), s'ajoutant à l'anisotropie d'interface existant à l'interface oxyde/métal magnétique. De ce fait, l'anisotropie interfaciale et l'anisotropie de forme favorisent toutes les deux une orientation de l'aimantation hors du plan ce qui renforce considérablement l'anisotropie effective et permet ainsi de diminuer la taille des points mémoire en gardant une rétention suffisante. Ceci permet d'augmenter la stabilité thermique de la couche de stockage et ainsi d'étendre la scalabilité des points mémoire (qu'ils soient STT-MRAM ou SOT-MRAM). En effet, une couche épaisse possède des propriétés magnétiques beaucoup plus proches du matériau massif (bulk) qu'une couche très fine comme le sont les couches de stockage habituellement utilisées dans les p-STT-MRAMs de l'état de l'art (couches de 1.5nm à 2nm d'épaisseur). En particulier, les fluctuations thermiques se développent moins vite en fonction de la température que dans une couche très mince. En effet, il est connu que du fait du nombre réduit d'atomes voisins en surface d'une couche magnétique, la température d'ordre magnétique tend à s'abaisser dans les couches magnétiques de quelques plans atomiques d'épaisseur. Ceci veut dire que les fluctuations thermiques se développent de façon plus importante dans les couches très minces que dans les matériaux massifs de même composition. Dans le contexte des p-STT-MRAMs de l'état de l'art, ceci se traduit par une décroissance rapide de la magnétorésistance tunnel et de l'anisotropie magnétique en fonction de la température, ce qui est gênant si le dispositif doit fonctionner sur une large gamme de températures (-40°C à +150°C pour l'automobile) ou doit garder la mémoire pendant une opération de soudure pouvant entrainer une élévation de température à 260°C pendant une minute (solder reflow compliance). Ainsi, comme le courant d'écriture est proportionnel à l'énergie de barrière Eb=KV (K anisotropie effective de la couche magnétique active, V volume de cette couche), séparant un état magnétique de la mémoire (représentant le « 0 ») de l'autre état (représentant le « 1 »), la forte variation d'anisotropie K sur la gamme d'opération des STT-MRAMs conventionnelles conduit à une faible rétention à la limite supérieure de la gamme d'opération et à un fort courant d'écriture à la limite inférieure de la gamme d'opération. Grâce à l'utilisation de couches magnétiques épaisses comme proposé par K. Watanabe et al. et N. Perrissin et al., on diminue fortement cette variation thermique qui ressemble beaucoup plus à celle du matériau massif. Ainsi à titre d'exemple, le cobalt massif ne voit son aimantation varier que de quelques % (5 à 7%) entre -40°C et 150°C alors qu'en couches d'épaisseur 1.5nm, cette variation peut être de 30 à 40%. Le facteur de stabilité thermique, quant à lui, peut être ajusté en jouant sur la forme de la couche de stockage et en particulier sur son épaisseur. Comme il est connu de l'homme de l'art, la valeur recherchée pour ce facteur de stabilité thermique se situe entre 60 et 100 suivant le taux d'erreur acceptable pour la mémoire et sa capacité.

Un second avantage d'une couche de stockage épaisse concerne l'amortissement de Gilbert qui intervient directement dans le courant d'écriture. Tant qu'on reste dans le régime macrospin, l'amortissement de Gilbert qui intervient dans la valeur du courant d'écriture est l'amortissement de Gilbert moyenné sur tout le volume de la couche de stockage. Des optimisations sont alors possibles pour obtenir une forte magnétorésistance tunnel et un amortissement moyen faible comme expliqué plus loin.

De façon plus générale, ce concept de dispositifs spintroniques utilisant de telles couches magnétiques actives épaisses peut être utilisé pour d'autres fonctionnalités comme des capteurs de champ magnétique ou dispositifs spintroniques radio fréquence, permettant de réduire leur dimension vers des tailles inférieures à quelques dizaines de nanomètres.

La principale difficulté associée à ces dispositifs spintroniques de dimension inférieure à 30nm comportant des couches magnétiques épaisses concerne leur fabrication. Il n'existe en effet pas pour l'instant de procédé de fabrication fiable permettant de former des réseaux de dispositifs élémentaires de résolution F inférieure à 30nm comportant des couches magnétiques épaisses d'épaisseur de même ordre de grandeur que leur diamètre et avec une périodicité (« pitch » selon la dénomination anglo-saxonne) inférieure à 3F.

Ainsi, bien que le document FR3027453B1 propose un procédé de fabrication de dispositifs spintroniques de résolution inférieure à 30nm, celui-ci présente des inconvénients dans le cas où la couche de stockage de la jonction tunnel magnétique est épaisse. En effet, les méthodes de dépôt couramment utilisées pour les dépôts de jonctions tunnel magnétiques, en particulier la pulvérisation cathodique, ne sont pas très directives. Autrement dit, il existe une dispersion angulaire des espèces déposées lors du dépôt. De ce fait, lorsque le dépôt est réalisé sur des piliers métalliques préstructurés comme décrit précédemment, le matériau déposé tend à déborder sur les flancs des piliers ce qui peut conduire à des effets de courts-circuits électriques à travers la barrière tunnel et entre le dépôt au sommet des plots et dans les tranchées séparant les plots. Ce problème est d'autant plus marqué que l'épaisseur du matériau déposée est importante. Par ailleurs, pour éviter un contact direct entre le dépôt dans les tranchées entre les piliers et le dépôt au sommet des piliers préstructurés, il faut que la hauteur des piliers préstructurés soit significativement plus grande que l'épaisseur du dépôt réalisé. Si le dépôt est épais, les piliers préstructurés doivent avoir un rapport d'aspect (hauteur/diamètre) important ce qui complique leur fabrication.

Il existe donc un besoin de pouvoir fabriquer un dispositif spintronique comportant une couche magnétique d'épaisseur de même ordre de grandeur que son diamètre moyen sans que se posent ces problèmes. Les documents US 2015/194595 A1, US 2015 / 236251 A1, US 2013/015540 A1, US 2016 218280 et US 2013 / 029431 A1 divulguent des autres exemples de l'art antérieur. Il n y a aucune divulgation des piliers magnétiques tels que définis par la revendication 1.

### RESUME DE L'INVENTION

L'invention offre une solution aux problèmes évoqués précédemment, en proposant un procédé de fabrication d'un dispositif spintronique.

Un objet de la présente invention concerne ainsi un procédé de fabrication d'un dispositif spintronique comportant au moins un espaceur non-magnétique, une couche de référence et une couche de stockage comportant au moins un pilier magnétique comprenant les étapes suivantes :
- Déposer au moins une couche sacrificielle d'une épaisseur au moins égale à celle du pilier que l'on cherche à former sur un substrat comportant au moins une zone conductrice émergent à la surface du substrat ;
- Former au moins une cavité évasée, traversant ladite couche sacrificielle, dont la base est en vis-à-vis de la surface de ladite zone conductrice du substrat;
- Déposer au moins une couche magnétique dans ladite cavité, d'épaisseur au moins égale à celle du pilier magnétique que l'on cherche à former ;
- Supprimer l'excès de couche magnétique en dehors de la cavité et planariser la surface de ladite couche magnétique pour atteindre l'épaisseur visée de pilier magnétique ;
- Retirer au moins une partie de la couche diélectrique afin de former à partir de la couche magnétique restante, au moins un pilier magnétique formant tout ou partie de la couche de stockage du dudit dispositif spintronique ;
- Déposer au moins l'espaceur non magnétique et la couche de référence de sorte que chaque pilier magnétique soit surmonté de au moins ledit espaceur non-magnétique et ladite couche de référence ;
- Remplir les espaces entre les piliers magnétiques par un matériau diélectrique ;
- Réaliser un polissage pour supprimer l'excès de matériau diélectrique de remplissage déposé à l'étape précédente afin d'avoir accès à la surface supérieure de l'élément surmontant le pilier ;
- Former un contact électrique à la surface de l'élément surmontant le pilier magnétique.

Grâce à l'invention, l'ensemble du dispositif spintronique est plus simple à fabriquer que dans l'état de l'art. En effet, le pilier magnétique qui réalise tout ou partie de la couche de stockage, peut être fabriqué par un procédé bien contrôlé en microélectronique par exemple en utilisant un procédé damascène pour la fabrication des interconnections ou des via entre les différents niveaux de métaux en technologie CMOS. Le procédé consiste à remplir de matériau magnétique une cavité ou une tranchée préalablement formée dans un matériau diélectrique suivi d'un polissage mécanochimique. Ensuite on retire tout ou partie du matériau diélectrique entourant les piliers ainsi formés pour obtenir un ou une pluralité de piliers magnétiques en relief sur le substrat. Le reste des couches formant le dispositif spintronique est déposé sur le pilier magnétique. Du matériau se dépose au sommet des piliers et une autre partie se dépose autour des piliers, dans les tranchées les séparant. Ce matériau qui tombe dans les tranchées ne dérange pas le fonctionnement du dispositif. Il peut même l'aider en jouant le rôle d'écran absorbant le flux magnétique émanant du dépôt au sommet des piliers. Avantageusement, le dépôt des autres couches formant l'empilement actif est auto-aligné sur les piliers magnétiques, ce qui simplifie grandement la fabrication du dispositif.

Finalement, le dispositif selon l'invention comprendra un pilier magnétique de forme évasée réalisant la fonction de couche épaisse magnétique comprise dans la couche de stockage, ledit pilier magnétique étant de hauteur H de l'ordre de grandeur d'une dimension caractéristique D d'une section planaire du pilier, surmonté et entouré par les autres couches, formant le dispositif spintronique. Par même ordre de grandeur, on entend que la hauteur H du pilier peut être entre 0.25 et 5 fois une dimension caractéristique de la section planaire du pilier, cette dimension caractéristique étant par exemple dans le cas d'un pilier conique, son diamètre moyen, cette moyenne étant effectuée sur la hauteur du pilier.

Selon un mode de réalisation avantageux, chaque pilier magnétique est entouré dans la zone séparant les piliers par un empilement comportant au moins ledit espaceur non magnétique et ladite couche de référence, cet empilement ne présentant pas de contact électrique avec ledit pilier magnétique, et étant enterré par ledit matériau diélectrique de remplissage.

Outre les caractéristiques qui viennent d'être évoquées dans le paragraphe précédent, le procédé selon un aspect de l'invention peut présenter une ou plusieurs caractéristiques complémentaires parmi les suivantes, considérées individuellement ou selon toutes les combinaisons techniquement possibles :
- L'étape de dépôt de l'espaceur non magnétique et la couche de référence est réalisée de sorte que chaque pilier magnétique soit en outre entouré de au moins ledit espaceur non magnétique et ladite couche de référence et de sorte qu'il n'y ait pas de contact électrique entre ledit pilier magnétique et au moins ledit espaceur non-magnétique et la couche de référence entourant ledit pilier ;
- L'étape de formation des cavités est réalisée avec une approche « damascène » ou « double-damascène » ;
- Les cavités réalisées lors de l'étape de formation des cavités ont une section à leur base plus petite qu'à leur sommet ;
- La couche magnétique est formée de plusieurs couches de matériaux magnétiques et non magnétiques, de telle sorte que la proportion de matériaux magnétiques par rapport aux matériaux non magnétiques soit suffisante pour que l'anisotropie de forme du pilier magnétique soit fortement réduite dans le plan voire qu'elle devienne hors du plan ;
- La couche magnétique est formée majoritairement d'un matériau magnétique présentant un faible amortissement de Gilbert ;
- Le dispositif spintronique est un point mémoire magnétique à accès aléatoire de type « perpendicular shape anisotropy spin-transfer torque » ou PSA-STT-MRAM ;
- Le dispositif spintronique est un point mémoire magnétique à accès aléatoire de type « perpendicular shape anisotropy spin-orbit torque » ou PSA-SOT-MRAM ;
- Le dispositif spintronique est un capteur de champ magnétique ;
- Le dispositif spintronique est un composant radiofréquence ;

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique du résultat d'un procédé de fabrication de dispositif spintronique selon l'état de l'art.
- Les figures 2a et 2b montrent un dispositif spintronique obtenu par le procédé selon l'invention.
- La figure 3 montre une représentation schématique des étapes du procédé selon l'invention.
- La figure 4 montre une représentation schématique du résultat de la première étape du procédé selon l'invention.
- La figure 5 montre une représentation schématique du résultat de la deuxième étape du procédé selon l'invention.
- La figure 6 montre une représentation schématique du résultat de la troisième étape du procédé selon l'invention.
- La figure 7 montre une représentation schématique du résultat de la quatrième étape du procédé selon l'invention.
- La figure 8 montre une représentation schématique du résultat de la cinquième étape du procédé selon l'invention.
- La figure 9 montre une représentation schématique du résultat de la sixième étape du procédé selon l'invention.
- Les figures 10a et 10b illustre la formation d'une jonction tunnel magnétique par pulvérisation cathodique lors du procédé selon un mode de réalisation de l'invention.
- La figure 10b montre une représentation schématique du résultat de la sixième étape du procédé selon un mode de réalisation de l'invention.
- La figure 11 montre une représentation schématique du résultat de la septième étape du procédé selon l'invention.
- La figure 12 montre une représentation schématique du résultat de la huitième étape du procédé selon l'invention.
- La figure 13 montre une représentation schématique du résultat de la neuvième et dernière étape du procédé selon l'invention.
- La figure 14 représente une pluralité de points mémoire d'un dispositif spintronique à couche magnétique active épaisse SOT-MRAM obtenus par le procédé selon l'invention.

### DESCRIPTION DETAILLEE

Sauf précision contraire, un même élément apparaissant sur des figures différentes présente une référence unique.

Les Figures 2a et 2b représentent un mode de réalisation d'un dispositif spintronique 200 objet du procédé de fabrication selon l'invention.

[Fig. 2a] représente le dispositif spintronique 200 comprenant un pilier magnétique 240 de hauteur H et de dimension caractéristique D.

Le dispositif spintronique comprend de plus une pluralité de couches magnétiques et non magnétiques 250 en contact électrique avec le pilier magnétique 240 et une électrode supérieure 260 en contact électrique avec la couche supérieure de la pluralité de couches 250. Le dispositif spintronique 200 est en contact électrique avec une zone conductrice 220 formée dans un substrat 210.

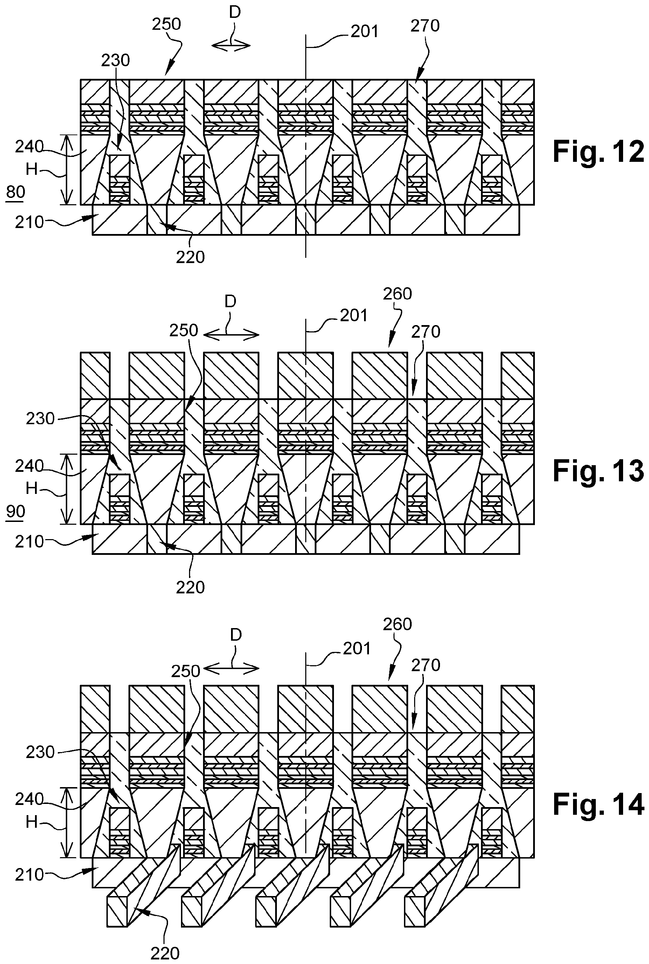

La zone conductrice 220 peut être un via tel que ceux réalisés en technologie CMOS (Complementary Metal Oxide Semiconductor). Le pilier magnétique 240 est formé de manière à être en contact électrique avec la zone conductrice 220, c'est-à-dire que la base du pilier magnétique 240 soit en contact avec la zone conductrice et par exemple que l'axe vertical 201 du pilier magnétique 240 soit aligné avec l'axe horizontal de la zone conductrice 220 tel que représenté sur la Figure 14 ou avec le centre du via conducteur 220.

Par « axe vertical 201 du pilier magnétique 240 » on entend l'axe vertical 201 passant par le centre de la base du pilier magnétique 240 et par le centre du sommet du pilier magnétique 240.

Par « axe horizontal de la zone conductrice 220 » on entend l'axe horizontal coupant la zone conductrice 220 en deux dans le sens de la longueur selon le plan du substrat 210 lorsque la zone conductrice a une forme de ligne horizontale comme sur la Figure 14.

Par la suite, le terme « zone conductrice 220 » sera employé pour désigner une zone conductrice ou un via conducteur indifféremment.

Le pilier magnétique 240 a une aimantation commutable entre deux états d'aimantation sensiblement normale au plan du substrat 210 : aimantation vers le haut ou vers le bas.

Le pilier magnétique 240 est de hauteur H de même ordre de grandeur qu'une dimension caractéristique D d'une section planaire du pilier magnétique 240.

Par « de même ordre de grandeur » on entend que le pilier magnétique 240 est d'une hauteur H se situant entre 0.25 et 5 fois une dimension caractéristique D d'une section planaire du pilier magnétique 240.

On entend par « section planaire du pilier magnétique 240 » une section du pilier magnétique 240 selon le plan du substrat 210.

On entend par « dimension caractéristique D » une dimension de ladite section planaire. Par exemple, en cas de pilier magnétique 240 ayant une section circulaire, la dimension caractéristique D d'une section planaire du pilier magnétique 240 peut être choisie comme étant le diamètre moyen du pilier, ce diamètre étant la valeur moyennée des diamètres sur la hauteur du pilier. En cas de section elliptique, la dimension caractéristique D peut être choisie comme étant le double du petit axe ou du grand axe de l'ellipse.

Le pilier magnétique 240 a pour utilité de structurer naturellement le dispositif spintronique 200. En effet, le pilier magnétique 240 est de forme évasée, c'est-à-dire que la surface de sa base est inférieure à la surface de son sommet. Grâce à sa forme, lors du dépôt de la pluralité de couches magnétiques et non magnétiques 250, les couches se discrétisent au sommet du pilier magnétique 240 et autour de celui-ci. Cela permet de ne pas avoir besoin de graver a posteriori chaque couche de la pluralité de couches 250. Un autre avantage est que le dépôt de la pluralité des couches formant le dispositif spintronique est automatiquement aligné sur les piliers magnétiques 240 ce qui simplifie la fabrication du dispositif.

Par la suite, il sera fait référence aux couches qui sont déposées au sommet du pilier magnétique 240 par les termes « couches 250 » tandis qu'il sera fait référence aux couches déposées autour du pilier magnétique 240 par les termes « couches 230 ».

Lors de la fabrication de plusieurs dispositifs spintroniques sur le même substrat 210, les piliers magnétiques 240 sont suffisamment isolés électriquement les uns des autres, malgré la présence de la pluralité de couches 230 au fond des tranchées séparant les piliers 240, grâce au fait que les couches 230 ne touchent pas les flancs à la base des piliers. En effet, le dépôt des couches 230 et 250 s'effectuant selon un procédé sensiblement directif, de préférence par dépôt physique en phase vapeur (PVD) tel que la pulvérisation cathodique ou l'évaporation, la partie supérieure en surplomb de chaque pilier empêche par effet d'ombrage le dépôt du matériau au pied des flancs. En fait, la pluralité de couches 230 au fond des tranchées séparant les piliers peut même améliorer le fonctionnement du dispositif en jouant le rôle d'écran absorbant le flux magnétique émanant du dépôt des couches 250 au sommet des piliers magnétiques 240.

Le pilier magnétique 240 et les couches 230 et 250 sont noyées dans un matériau diélectrique 270 afin de renforcer la structure du dispositif et de pouvoir réaliser ensuite le contact électrique supérieur 260.

[Fig. 2b] représente le pilier magnétique 240 et les autres couches magnétiques et non-magnétiques formant le dispositif spintronique 200. Par « autres couches magnétiques et non magnétiques », on entend toutes les couches formant le dispositif spintronique 200 sauf la ou les couches formant le pilier magnétique 240.

Le dispositif spintronique 200 selon le mode de réalisation comprend ainsi au moins une couche de stockage 255, un espaceur non magnétique 254, une couche de référence 253 d'aimantation fixe hors du plan, une couche synthétique antiferromagnétique 252 et une couche supérieure d'ouverture du contact électrique 251.

La couche de stockage 255 comprend le pilier magnétique 240 et une couche 259 magnétique. Cette couche 259 est composée par exemple d'une couche inférieure de transition en Mo de 0.2nm (non représentée) et d'une couche supérieure en alliage FeCoB de 2nm. Le pilier magnétique 240, en plus de naturellement structurer le dispositif spintronique lors de la fabrication, forme tout ou partie de la couche de stockage 255. La couche magnétique épaisse qui forme le pilier 240 va donc permettre de renforcer l'anisotropie effective hors plan des couches, du dispositif spintronique 200.

Lorsque l'espaceur 254 est une barrière tunnel, celle-ci est par exemple composée d'une couche de MgO de 1nm. Si cet espaceur est un conducteur non-magnétique, il peut être par exemple en cuivre ou en argent.

La couche de référence 253 d'aimantation fixe hors du plan est composée par exemple d'une couche inférieure interfaciale en alliage FeCoB de 1.7nm et d'une couche supérieure de transition en Mo de 0.2nm (non représentée).

La couche synthétique antiferromagnétique 252 est bien connue de l'homme du métier. Elle est composée de deux couches magnétiques 256 et 258 dont les aimantations sont couplées antiparallèlement à travers une fine couche 257 assurant un couplage antiparallèle entre les aimantations des couches magnétiques. La couche 258 est composée par exemple de Ta0.2nm/(Co0.4nm/Ta0.1/Pt0.5nm)₄. La couche 257 est composée par exemple de Ru de 0.8nm. La couche 256 est par exemple composée de (Co0.4nm/Ta0.1/Pt0.5nm)₆.

Enfin, la couche 251 de métal est relativement épaisse pour permettre l'ouverture du contact supérieur du dispositif spintronique 200. Elle est composée par exemple de TiN ou Ta et permet un contact électrique avec l'électrode 260.

[Fig. 3] représente schématiquement le procédé de fabrication 300 selon l'invention. La première étape 10 consiste à déposer une couche sacrificielle sur le substrat 210. La seconde étape 20 consiste à former une cavité évasée dans la couche sacrificielle. La troisième étape 30 consiste à remplir la cavité évasée de matériau magnétique. La quatrième étape 40 consiste à supprimer l'excès de matériau magnétique et à planariser. La cinquième étape 50 consiste à retirer tout ou partie de la couche sacrificielle. La sixième étape 60 consiste à déposer le reste des couches magnétiques et non magnétiques 230 et 250. La septième étape 70 consiste à remplir les espaces restants par un matériau diélectrique. La huitième étape consiste à supprimer du matériau diélectrique pour ouvrir les contacts supérieurs du dispositif spintronique 200. La neuvième étape consiste à former l'électrode supérieure 260.

Les différentes étapes du procédé 300 sont décrites plus en détail par la suite.

### Première étape

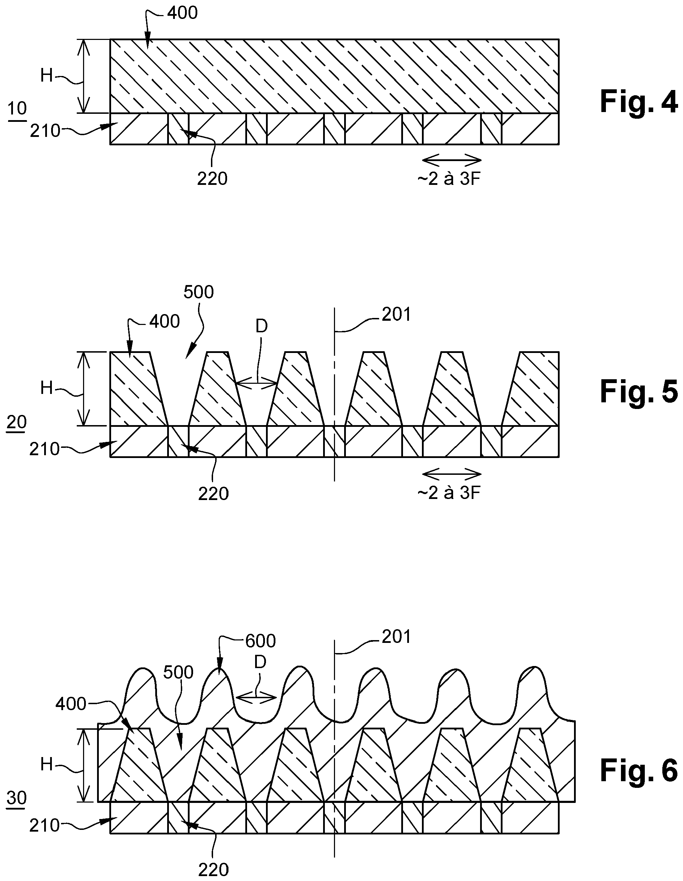

[Fig. 4] représente la première étape 10 du procédé de fabrication 300 du dispositif spintronique 200. Elle consiste en le dépôt d'une couche sacrificielle 400 d'épaisseur H sur un substrat 210 comportant des zones conductrices 220 émergents à la surface du substrat. Le substrat 210 sur lequel le procédé de l'invention est effectué consiste typiquement en une surface d'isolant électrique (par exemple en SiO2 ou SiOCH) percée de zones conductrices 220, typiquement en cuivre. Ce substrat peut être fabriqué par technologie CMOS et contient dans ce cas déjà des transistors de sélection, éventuellement des circuits logiques, et au moins le premier niveau de métallisation (communément appelé M1). La distance minimale entre les zones conductrices 220 est de l'ordre de F où F désigne la taille minimale des objets réalisés (résolution) dans la technologie utilisée. Mais cette distance peut prendre n'importe quelle valeur au-dessus de la valeur minimale F. Typiquement, un réseau de zones 220 avec une distance inter-zones centre à centre entre 2F et 3F sera utilisé. Dans le cas de circuits hybrides mémoire/logique, ce substrat 210 peut correspondre à une zone localisée sur une plaque complète. Le reste de la zone est alors protégé pendant la fabrication du point mémoire par un matériau sacrificiel ou par un isolant qui pourra être retiré en fin de procédé ou au cours du procédé.

Le dépôt de la couche sacrificielle 400 peut être effectué par un procédé de dépôt physique par phase vapeur (PVD selon la dénomination anglo-saxonne «Physical vapor déposition ») comme la pulvérisation cathodique, bien connue de l'homme de l'art. Cette couche sacrificielle 400 est en fait la couche dans laquelle les piliers magnétiques vont être formés. Il est donc nécessaire que son épaisseur H soit au moins de l'ordre de grandeur d'une dimension caractéristique D du pilier magnétique 240, afin que le pilier magnétique 240 ait une hauteur H suffisante par la suite pour permettre au dispositif de bénéficier d'une anisotropie de forme perpendiculaire (PSA selon la dénomination anglo-saxonne « Perpendicular Shape Anisotropy »). La hauteur H doit aussi être significativement plus grande que l'épaisseur des autres couches magnétiques et non-magnétiques 250, 230 du dispositif spintronique 200 qui vont être déposées à l'étape 60 pour que le dispositif 200 se structure naturellement au-dessus du pilier magnétique 240 et pour éviter les court-circuits inter-piliers 240.

Cette couche 400 va être en fait retirée entièrement ou en partie à l'étape 50. Ainsi, il est nécessaire que le matériau formant la couche 400 soit différent du matériau formant le substrat 210 et entourant les zones conductrices 220 pour qu'il puisse être enlevé par un solvant ou attaque plasma approprié sans enlever l'oxyde entourant les zones conductrices 220 et sans attaquer les piliers magnétiques 240. Le matériau formant cette couche 400 est de préférence un matériau isolant utilisé en technologie CMOS pour l'isolation électrique des lignes conductrices ou via conducteurs, préférentiellement un oxyde de silicium SiO2, mais il peut également être un autre matériau comme un polymère, un matériau SiOCH, du Si3N4 ou encore du SiCN. Ce matériau doit être isolant s'il n'est que partiellement retiré mais n'a pas besoin d'être isolant s'il est entièrement retiré à l'étape 50.

Dans une variante à l'invention, la couche 400 peut être formée de plusieurs couches, avec par exemple une couche inférieure en SiCN et une couche supérieure en SiO2. La couche inférieure peut ainsi jouer le rôle de barrière diélectrique à la diffusion du métal des zones conductrices 220 du substrat 210.

### Deuxième étape

[Fig. 5] représente schématiquement la deuxième étape 20 du procédé 300. Elle consiste à former au moins une cavité évasée 500, traversant la couche sacrificielle 400, dont la base est en vis-à-vis de la surface de la zone conductrice 220 du substrat 210. Par « dont la base est en vis-à-vis de la surface de la zone conductrice 220 du substrat 210 », on entend par exemple dans le cas où la zone conductrice 220 est un via utilisé en microélectronique pour connecter deux niveaux de conducteurs, que l'axe vertical 201 de ladite cavité 500 est aligné avec l'axe vertical de la zone conductrice 220 du substrat 210 pour former un contact électrique entre la zone conductrice 220 et le pilier magnétique 240. La formation de la cavité 500 peut se faire par exemple par gravure damascène ou double damascène du matériau formant la couche sacrificielle 400.

Le procédé « damascène » constitue une alternative à la gravure plasma (IBE ou plasma réactive) pour structurer les éléments de stockage des mémoires MRAM, CBRAM et OxRAM. Ce procédé, habituellement utilisé pour la fabrication des interconnections métalliques de circuits intégrés, consiste à définir l'empreinte de l'élément dans un matériau isolant, puis à déposer les matériaux sur l'ensemble du substrat. Un polissage mécano-chimique permet de supprimer l'excès de matériaux en dehors de l'empreinte.

Cette deuxième étape 20 de formation de la cavité 500 pourra être réalisée avec une approche « simple damascène » ou « double damascène ». Un exemple d'approche « simple damascène » est représenté Figure 5, tandis que l'approche « double-damascène » est non représentée. Dans le procédé « simple damascène », un seul motif (par exemple un via ou une ligne) est formé puis rempli de métal dans la couche diélectrique 400, alors que le procédé « double damascène » remplit simultanément deux motifs superposés, par exemple un via d'interconnexion et une ligne d'interconnexion recouvrant le via. Dans ce dernier cas, on obtient des piliers magnétiques 240 en deux parties. Il est ainsi possible d'obtenir des structures avec un profil en encoche, c'est-à-dire pour lesquels la section de la partie inférieure est plus petite que la section de la partie supérieure.

Les piliers magnétiques 240 réalisés par une approche damascène présentent un flanc légèrement réentrant car ce type de profil est favorable à la métallisation. On recherchera ici ce type de profil réentrant.

Il va de soi que les flancs des trous n'ont pas besoin d'être droits comme sur la Figure 5. Ils peuvent être incurvés, voire en marche d'escalier. Pour toutes ces formes de piliers magnétiques 240, l'important est que le matériau magnétique qui va remplir ces cavités 500 à l'étape 30 présente des flancs suffisamment surplombants pour éviter les courts-circuits inter-piliers 240 comme expliqué précédemment et une anisotropie de forme perpendiculaire convenablement ajustée par rapport à la spécification recherchée pour l'application visée. L'inclinaison des flancs que l'on cherchera à obtenir dépend de la directivité des dépôts des autres couches 250 constituant l'empilement magnétique déposées à l'étape 60. Cette inclinaison peut être typiquement entre 5° et 45° à partir de l'axe 201. Par ailleurs, comme dit précédemment, l'aspect surplombant des flancs peut être réalisé en donnant non pas une forme tronc conique inversée aux cavités mais par exemple une forme de deux cylindres à flans verticaux empilés coaxiaux, le cylindre supérieur ayant un diamètre supérieur au diamètre du cylindre inférieur.

### Troisième étape

[Fig. 6] représente schématiquement l'étape 30 du procédé 300. Elle consiste à déposer au moins une couche épaisse magnétique 600 dans la cavité 500, d'épaisseur H de même ordre de grandeur qu'une dimension caractéristique D de la cavité 500. Cette couche épaisse magnétique 600 va former les piliers magnétiques 240 sur lesquels vont être déposés le reste des couches 250 formant le dispositif spintronique 200.

Avant le dépôt du matériau dans les cavités évasées 500, une gravure peut être réalisée pour enlever d'éventuels résidus ou couches d'oxydes qui pourraient exister au fond des cavités évasées 500 et nuiraient au bon contact électrique entre les lignes conductrices 220 du substrat 210 et la couche épaisse magnétique 600.

Dans le cas de jonctions tunnel magnétiques pour la réalisation de STT-MRAM à anisotropie perpendiculaire, le matériau qui forme la couche épaisse magnétique 600 est préférentiellement un matériau à faible amortissement de Gilbert tel qu'un alliage FeCoB riche en Fe voire du fer pur ou du Permalloy ou un alliage d'Heusler à faible amortissement (par exemple Co₂FeAl, Co₂FeAl_{0.5}Si_{0.5}, Co₂Fe_{0.4} Mn_{0.6}Si, Co₂Fe_{0.4}Ga_{0.5}Ge_{0.5}).

Une alternative à l'utilisation d'une couche magnétique épaisse monomatériau est l'utilisation d'un empilement de plusieurs couches de matériaux magnétiques et non magnétiques pour former la couche épaisse magnétique 600. En particulier, une couche tampon non magnétique (« buffer » selon la dénomination anglo-saxonne) peut être déposée en premier pour promouvoir la croissance des couches suivantes (par exemple du Ta ou du NiFeCr 3nm ou des matériaux communément utilisés comme barrières de diffusion dans la fabrication des interconnections comme du TiN ou du TaN). Cette couche tampon peut être surmontée d'une fine couche de cobalt comme celle utilisée comme liner dans la fabrication des interconnections pour favoriser la croissance des couches suivantes, elle-même surmontée d'une couche magnétique épaisse à faible amortissement de Gilbert (par exemple le NiFe, le Fe ou le FeB), pouvant elle-même être surmontée d'une couche d'un autre matériau magnétique pouvant être amorphe (par exemple un alliage FeCoB, comme représenté Fig 2b couche 259). Cette couche peut également incorporer de fines laminations (épaisseur de l'ordre de 0.1 à 0.4nm d'épaisseur) de matériaux tels que Ta, W, Mo, etc, capables d'absorber l'élément amorphisant tel que le bore contenu dans les alliages FeCoB ou FeB lors des recuits nécessaires à la fabrication du dispositif final. Il peut être préférable de terminer par un matériau amorphe pour que lors de l'étape 40 de planarisation, la surface de ce pilier magnétique 240 soit très lisse. En effet, dans le cas de matériaux polycristallins, si la technique de polissage mécanochimique (CMP selon la dénomination anglo-saxonne « Chemical mechanical polishing ») est utilisée pour planariser, cela peut conduire à des arrachages de grains métalliques générant une rugosité importante de la surface des piliers 240. Ce matériau amorphe ne doit pas être trop oxydable en surface pour qu'à l'issue de l'étape 40, l'éventuelle couche d'oxyde de surface puisse facilement être enlevée par une gravure surfacique préalable au dépôt des couches suivantes. En effet, une telle couche d'oxyde interfaciale pourrait nuire à l'obtention si besoin d'un bon couplage magnétique entre le pilier magnétique et la première couche 259 déposée à l'étape 60 et pourrait rajouter une résistance électrique qui pourrait être du même ordre de grandeur ou supérieure à celle de l'espaceur non magnétique 254.

Les différentes couches pouvant former la couche épaisse magnétique 600 peuvent être déposées par différentes méthodes connues de l'homme du métier en microélectronique telle que le dépôt de couches atomiques (ALD selon la dénomination anglo-saxonne « Atomic Layer Décomposition »), le dépôt chimique en phase vapeur (CVD selon la dénomination anglo-saxonne « Chemical Vapor Déposition »), le dépôt physique en phase vapeur (PVD selon la dénomination anglo-saxonne « Physical Vapor Déposition ») en particulier la pulvérisation cathodique voire même l'électrodéposition (en particulier pour le Permalloy alliage doux à base de Ni et de Fe dont une des compositions possibles est Ni₈₀Fe₂₀).

### Quatrième étape

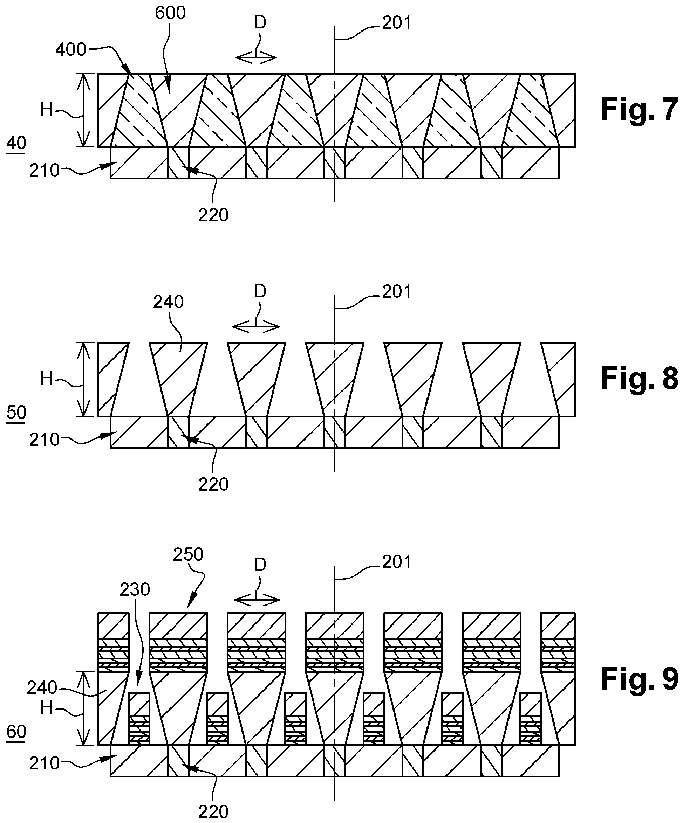

[Fig. 7] représente schématiquement le résultat de l'étape 40. Cette étape consiste à supprimer l'excès de couche épaisse magnétique 600 en dehors de la cavité 500 et à planariser la surface de ladite couche épaisse magnétique 600. Cette étape 40 peut être réalisée grâce à un polissage, par exemple un polissage mécano chimique (CMP), procédé bien connu de l'homme du métier. L'objectif de cette quatrième étape 40 est d'obtenir des piliers magnétiques 240 de faible rugosité de surface pour permettre la croissance du reste du dispositif spintronique 200. Pour une jonction tunnel magnétique, on cherchera typiquement à avoir une rugosité de surface inférieure à 0.4nm RMS pour obtenir une bonne croissance du reste de la structure et éviter la formation de ponts métalliques à travers la couche de barrière tunnel 254.

### Cinquième étape

[Fig. 8] représente schématiquement le résultat de l'étape 50. Cette étape consiste à retirer au moins une partie de la couche sacrificielle 400 afin de former au moins un pilier magnétique 240. Ce retrait de la couche sacrificielle 400 entourant les piliers magnétiques 240 est préférentiellement effectué de façon uniforme. Ainsi, comme indiqué précédemment, il est nécessaire que le matériau formant la couche 400 soit différent du matériau formant le substrat 210 et entourant les zones conductrices 220 pour qu'il puisse être enlevé par un solvant approprié sans enlever le matériau formant le substrat 210 entourant les zones conductrices 220 et sans attaquer les piliers magnétiques 240.

En fonction du matériau utilisé pour la couche sacrificielle 400, ce procédé de retrait de la couche sacrificielle 400 pourra être effectué, sans que cela ne soit limitatif, par attaque chimique. Dans le cas où le matériau formant la couche sacrificielle 400 entourant les piliers magnétiques 240 est un isolant de type SiO2, ce procédé pourra être effectué par voie chimique en utilisant à titre d'exemple une solution d'acide fluorhydrique diluée ou de l'acide fluorhydrique en phase vapeur. Ce retrait pourra également être effectué par voie sèche en utilisant un procédé de type Siconi tel que décrit dans le document [Tavernier, A.; Favennec, L.; Chevolleau, T. & Jousseaume, V. c. Innovative gap-fill strategy for and nm shallow trench and isolation and ratio and : IEEE, 2012]. Pour un isolant à base de carbone, on pourra utiliser un plasma à base d'oxygène. Pour un matériau SiOCH poreux, on pourra utiliser la combinaison d'un plasma d'oxygène suivi d'une attaque chimique en acide fluorhydrique dilué qui retirera la partie du matériau SiOCH poreux modifiée par le plasma d'oxygène. Le procédé de retrait de l'isolant ne doit pas conduire à une rugosification de la surface du pilier magnétique 240 pour assurer une compatibilité avec le dépôt des autres couches 250 formant l'élément magnétorésistif réalisé à la surface du pilier magnétique 240 à l'étape 60. L'épaisseur de couche diélectrique 400 ainsi retirée doit être significativement plus grande que la somme des épaisseurs des autres couches 250, soit plus de 1 fois l'épaisseur cumulée des dites couches 250, par exemple 1,2 fois et de préférence au moins 2 fois. L'épaisseur de couche sacrificielle 400 retirée à cette étape sera ajustée en jouant sur le temps de procédé.

Dans une variante de mise en oeuvre, la couche diélectrique 400 est retirée entièrement. Les piliers magnétiques 240 tiennent debout sur le substrat 210, même en l'absence de la couche 400 (puis l'ensemble de la structure sera consolidé par le matériau diélectrique de remplissage 270).

A la fin de cette étape 50, on obtient au moins un pilier magnétique 240 de hauteur H de même ordre de grandeur qu'une dimension caractéristique planaire D, de forme évasée et formant une couche épaisse magnétique comprise dans la couche de stockage 255, sur lequel on va pouvoir déposer le reste des couches magnétiques et non magnétiques 250 formant le dispositif spintronique 200.

### Sixième étape

[Fig. 9] représente schématiquement le résultat de l'étape 60. Elle consiste en le dépôt du reste des couches magnétiques et non magnétiques 250 et 230, formant le dispositif spintronique 200 de sorte que :
- Chaque pilier magnétique 240 soit surmonté des couches 250 et entouré des couches 230 et
- Qu'il n'y ait pas de contact électrique entre le pilier magnétique 240 et lesdites couches 230 entourant ledit pilier magnétique 240.

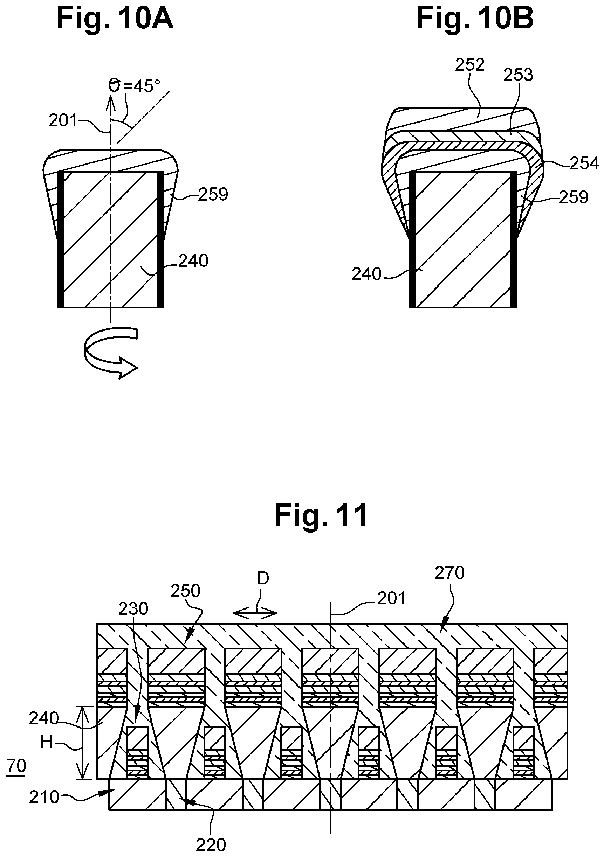

Le dépôt du reste des couches magnétiques et non-magnétiques 250 aux sommets des piliers magnétiques 240 peut comprendre le dépôt d'un ou plusieurs matériaux, suivant la technologie de mémoires ou d'éléments logiques envisagée. Les différentes couches magnétiques et non-magnétiques 250, 230 peuvent être déposées par des techniques différentes et suivant des incidences différentes (cf. Figures 9, 10a et 10b).

La pulvérisation cathodique est avantageusement utilisée à l'étape 60. Cette technique présente une certaine directivité permettant de diriger le dépôt de matériau résistif vers les piliers magnétiques 240, notamment à leur sommet 250. Toutefois, une partie du matériau résistif et du matériau de couverture se déposent également au fond des tranchées situées entre les piliers magnétiques 240, voire sur une partie des flancs des piliers suivant l'incidence du dépôt et la dispersion angulaire du flux d'atomes issus de la cible pulvérisée, formant alors des dépôts résiduels 230. En incidence normale par rapport à la surface du substrat et avec une technique de dépôt suffisamment directive (cas représenté sur la figure 9), ces dépôts résiduels 230 sont localisés autour du centre des tranchées et ne se déposent pas sur les flancs des piliers magnétiques 240. Plus les flancs des piliers magnétiques 240 sont surplombants, moins les dépôts 230 s'étalent à proximité de la base des flancs

La formation de flancs des piliers magnétiques 240 en retrait empêche donc le dépôt simultané de matériau résistif sur deux flancs se faisant face et appartenant à des piliers différents, ce qui évite un court-circuit entre ces deux piliers magnétiques 240. De préférence, la pulvérisation cathodique est collimatée afin d'augmenter la directivité du dépôt et donc diminuer l'étendue des dépôts résiduels 230 au fond des tranchées. Les dépôts 230 peuvent être laissés tels quels. Grâce à la discontinuité électrique sur les flancs des piliers magnétiques 240, ils ne perturbent pas de façon significative le fonctionnement du dispositif spintronique. En particulier, ils ne créent pas de courts-circuits inter-piliers 240. En fait, la pluralité de couches 230 au fond des tranchées séparant les piliers 240 peut même améliorer le fonctionnement du dispositif 200 en jouant le rôle d'écran absorbant le flux magnétique émanant du dépôt des couches 250 au sommet des piliers magnétiques 240.

[Fig.10a] représente en détail la formation d'une jonction tunnel magnétique de mémoire MRAM au sommet d'un pilier magnétique 240 par pulvérisation cathodique en incidence oblique du matériau diélectrique constituant la barrière tunnel selon une variante de l'invention. La couche magnétique 259 est d'abord déposée en incidence normale sur le pilier magnétique 240. A cause de la dispersion angulaire du flux pulvérisé par pulvérisation cathodique, la couche magnétique 259 peut déborder sur la partie supérieure des flancs du pilier 240 comme représenté sur la Figure 10a. Cette couche magnétique 259 forme la partie de la couche de stockage en contact avec l'espaceur non-magnétique 254.

[Fig.10b] représente en détail la formation d'une jonction tunnel magnétique de mémoire MRAM au sommet d'un pilier magnétique 240 par pulvérisation cathodique en incidence oblique du matériau diélectrique constituant la barrière tunnel selon la même variante de l'invention que la Figure 10a.

Lorsque l'espaceur non magnétique 254 est une barrière tunnel, le dépôt de la couche de barrière tunnel 254 en MgO sur la couche de stockage formée par le pilier magnétique 240 et la couche magnétique 259 est avantageusement réalisé par pulvérisation cathodique en incidence oblique selon un angle θ mesuré par rapport à l'axe 201 du pilier magnétique 240, par exemple égal à 45°, alors que le substrat 210 est en rotation. Ceci permet de complètement encapsuler le pilier magnétique 240 dans le MgO et ainsi minimiser les risques de courts-circuits en bord de piliers 240.

Ainsi, un gradient latéral d'épaisseur de la couche de barrière tunnel 254 en MgO peut être obtenu en jouant sur l'incidence du dépôt. En utilisant un angle d'incidence élevé (se rapprochant d'une incidence rasante), on peut obtenir une épaisseur de MgO supérieure en bord de pilier et sur les flancs du pilier 240 qu'au centre de la surface supérieur du pilier. Ce gradient est particulièrement avantageux lorsque le dispositif final est utilisé par exemple comme élément de mémoire MRAM. En effet, lorsqu'une tension est appliquée de part et d'autre de la jonction tunnel magnétique, le courant électrique circule à travers la couche de barrière tunnel 254 et préférentiellement au centre de celle-ci, c'est-à-dire dans la portion où son épaisseur est la plus faible. Ainsi, on peut réduire l'impact d'éventuels défauts de bord sur les propriétés électriques et magnétiques des points mémoire et ainsi réduire la variabilité d'un point mémoire à l'autre dans une mémoire MRAM.

La formation du dispositif spintronique 200 s'achève par le dépôt de la couche de référence 253 sur l'espaceur non magnétique 254, le dépôt des couches formant la couche synthétique antiferromagnétique SAF 252, puis l'élément de couverture 251 (non représenté) est déposé sur la couche 252. Ces dépôts (253, 252, 251) sont, de préférence, réalisés par pulvérisation cathodique collimatée selon une incidence normale, afin d'éviter que les couches 253, 252 et 251 ne débordent sur les flancs du pilier magnétique 240 (ce qui pourrait occasionner un court-circuit à travers la barrière tunnel lorsque le dispositif est une jonction tunnel magnétique).

Dans une alternative de mise en oeuvre, les couches 250 déposées sur les piliers magnétiques 240 peuvent aussi être un empilement à magnétorésistance géante comme une vanne de spin. Ceci peut être intéressant dans les applications où la densité de courant traversant le dispositif 200 doit être importante comme dans certaines applications radiofréquence ou de capteurs de champ magnétique. Par rapport à une jonction tunnel, la différence essentielle et que l'espaceur non-magnétique 254, au lieu d'être une barrière tunnel est alors un espaceur typiquement de cuivre et les couches entourant cet espaceur sont plutôt des alliages de type FeCoNi de structure cubique à face centrée (fcc selon la dénomination anglo-saxonne « face-centered cubic») comme il est connu de l'homme du métier.

### Septième étape

[Fig. 11] représente schématiquement le résultat de l'étape 70. La septième étape 70 consiste à remplir les espaces entre les piliers magnétiques 240 et entre les éléments 250 surmontant les piliers magnétiques 240 par un matériau diélectrique 270.

Diverses techniques de l'industrie microélectronique permettent de remplir de matériau diélectrique (généralement un oxyde) des structures à facteur de forme élevé (type STI, FinFET, transistor à grille « damascène »...) et/ou avec des flancs surplombants. On peut citer notamment le dépôt en phase gazeuse de films diélectriques liquides. Les diélectriques liquides sont semblables à un gel ayant les caractéristiques d'écoulement d'un liquide. En exploitant cette technique, on peut aisément remplir des structures avec des facteurs de forme supérieurs à 10, allant même jusqu'à 30.

Le matériau diélectrique liquide 270 pour le remplissage des tranchées inter-piliers de la figure 11 peut être choisi parmi Si3N4, SiO2, SiOxCyHz, SiOxHy et SiOxNyHz. Ces matériaux sont choisis pour leur résistivité électrique (avantageusement ρ > 0.1 Ω.cm) afin que les courants de fuite entre points mémoire soient minimisés. Par exemple, pour former un oxyde de silicium liquide, le substrat est exposé simultanément à un précurseur gazeux contenant du silicium et à un gaz oxydant. Le gaz contenant le silicium et le gaz oxydant sont, soit mélangés avant leur introduction dans le réacteur, soit injectés séparément dans le réacteur. Le précurseur contenant du silicium peut être un alkoxysilane, par exemple Hx-Si-(OR)y où x=0~3, x+y=4 et R désigne un groupe alkyl. Le silane (SiH4) et ses dérivés, tels que le tetraethoxysilane (TEOS), le triéthoxysilane (TES), le triméthoxysilane (TriMOS), le méthyltriméthoxysilane (MTMOS), le diméthyldiméthoxysilane (DMDMOS), le diéthoxysilane (DES), le diméthoxysilane (DMOS), l'héxaméthoxydisilane (HMODS) et le triphényléthoxysilane, ou bien encore le tétraoxyméthylcyclotétrasiloxane (TOMCTS), l'octaméthylcyclotétrasiloxane (OMCTS), le méthyltriéthoxyorthosilicate (MTEOS), le tétraméthylorthosilicate (TMOS), le 1-(triéthoxysilyl)-2-(diéthoxyméthylsilyl)éthane et le tri-t-butoxylsilanol sont d'autres exemples de précurseurs contenant du silicium. Le gaz oxydant peut être l'ozone (O3), le péroxyde d'hydrogène (H2O2), l'oxygène (02), l'eau (H2O), le méthanol, l'éthanol, l'isopropanol ou un oxyde nitrique (NO, N2O). La température du substrat et la pression de travail dans le réacteur permettent d'ajuster les vitesses de dépôt. Généralement, la température du substrat est comprise entre -30 °C et 100 °C (une température faible permet d'augmenter la vitesse de dépôt). La pression est par exemple comprise entre 100 mTorr et la pression atmosphérique.

L'avantage de cette technique par rapport aux autres techniques de dépôt en phase gazeuse est l'absence de vides ou cavités dans la couche de matériau diélectrique 270. Néanmoins, la présence de vides dans l'espace inter-piliers n'est pas préjudiciable, tant qu'une surface plane et continue est obtenue à l'issue de l'étape 80. Les techniques de dépôt physique en phase vapeur (PVD), de dépôt chimique en phase vapeur assisté par plasma (PECVD), de dépôt de couches atomiques (ALD) forment des couches d'épaisseur uniforme et sont donc susceptibles de former des vides dans les structures à fort facteur de forme, a fortiori lorsqu'elles ont des flancs en retrait (car elles conduisent rapidement à un pincement au sommet de la structure).

Une alternative aux procédés en phase gazeuse est le dépôt par centrifugation. Dans ce cas, un précurseur sol-gel est dilué dans un solvant et déposé sous forme liquide sur le substrat 210 en rotation. Sous l'effet de la force centrifuge, le liquide se répartit de façon uniforme à la surface du substrat. Les précurseurs polymérisent et le solvant s'évapore pour former un matériau diélectrique appelé « Spin On Glass » (SOG). L'épaisseur de la couche déposée est contrôlée par la viscosité du matériau et la vitesse de rotation du substrat 210. Les matériaux ainsi réalisés peuvent être des silices ou des silicones de type poly-méthylsiloxane, poly-métylsilsesquioxane, poly-oxycarbosilane, poly-dimétylsiloxane. Ils peuvent aussi être des polymères, tels que des résines planarisantes, par exemple celle commercialisée par la société « Honeywell » sous la dénomination « ACCUFLO ».

Un remplissage partiel des tranchées est envisageable, dans la mesure où l'isolation électrique est assurée même en présence de vides. Cela peut permettre de réduire la conductance inter-piliers et donc de minimiser les risques de diaphonie entre les piliers magnétiques 240.

Avec toutes les techniques de dépôt susmentionnées, il est difficile d'obtenir directement une surface plane au niveau de la face supérieure des éléments de couverture 251. Par conséquent, il est préférable de recouvrir entièrement les structures verticales avec le matériau diélectrique 270 et d'éliminer ensuite le matériau en excès.

### Huitième étape

[Fig. 12] représente schématiquement le résultat de l'étape 80. L'étape 80 consiste à réaliser un polissage pour supprimer l'excès de matériau diélectrique 270 de remplissage déposé à l'étape précédente 70 afin d'avoir accès à la surface supérieure de l'élément 251 surmontant le pilier magnétique 240.

Pour ce faire, on peut utiliser une méthode de polissage mécano-chimique (CMP) ou une gravure plasma de type « etch back » lorsque le dépôt du matériau diélectrique 270 tend déjà à produire une couche plane. Dans le cas d'une gravure, un procédé par plasma est utilisé pour graver le matériau planarisant et isolant. Les procédés typiquement utilisés sont basés sur des plasmas inductifs ou capacitifs à base de gaz fluorocarbonés tels que CF4, CHF3, CH2F2, C4F8, C4F6 ou leur combinaison avec éventuellement l'ajout de gaz additionnels tels que N2, 02, Ar ou leur combinaison. Le procédé est réalisé à une pression faible typiquement comprise entre 4 mTorr et 400 mTorr.

De façon classique, le procédé de polissage ou de gravure plasma est stoppé lorsque le matériau de couverture 251 est atteint. Ceci peut être réalisé en contrôlant les conditions de polissage/gravure, connaissant la vitesse de gravure et l'épaisseur du matériau à graver, ou en détectant la fin de gravure pendant le procédé (par exemple par réflectométrie ou spectroscopie d'émission optique).

### Neuvième étape

[Fig. 13] représente schématiquement le résultat de l'étape 90. La neuvième étape consiste à former une électrode supérieure 260 à la surface de l'élément 251 surmontant le pilier magnétique 240, de façon à faire circuler un courant électrique à travers le dispositif 200.

Cette étape 90 est réalisée avec les procédés standard de la microélectronique, soit avec un procédé dit cloisonné, soit avec un procédé dit damascène, soit avec un procédé de soulèvement (selon la dénomination anglo-saxonne « lift-off »).

Dans un procédé dit cloisonné, le métal (typiquement Al, Ti, TiN, Ta, TaN, W, Si fortement dopé) est déposé en couche mince sur la couche 251, puis un masque de gravure est formé par lithographie et/ou la combinaison du dépôt d'un masque dur, une lithographie, et la gravure du masque dur. Les motifs sont alors transférés dans le métal par un procédé de gravure préférentiellement anisotrope. Le masque est ensuite retiré par un procédé sec ou humide. Le procédé de gravure est adapté au métal composant l'électrode 260. Par exemple, pour une électrode en Al, on pourra utiliser un procédé plasma inductif à base de BCI3/CI2 avec une pression de l'ordre de 5 mTorr.

Dans un procédé dit damascène, un isolant est déposé en film mince sur la couche 251, puis un masque de gravure est formé à sa surface par lithographie et/ou la combinaison du dépôt d'un masque dur, une lithographie, et la gravure du masque dur. Un procédé de gravure est ensuite utilisé pour graver l'empreinte de l'électrode 260 dans le matériau isolant. Le métal composant l'électrode 260 est alors déposé dans la cavité ainsi formée, et l'excès de métal est supprimé par un polissage mécanochimique. Le matériau isolant est typiquement un oxyde de silicium ou un silicone. Le procédé de gravure est typiquement un procédé plasma à base de gaz fluorocarboné tel que CF4, CH2F2, CHF3, C4F8, C4F6 ou leur combinaison, avec éventuellement l'ajout de gaz additionnels tels que N2, 02, Ar ou leur combinaison. Le procédé est réalisé à une pression faible typiquement comprise entre 4 mTorr et 400 mTorr.

Le métal déposé peut être du Cu, Ti, Al, W. Le conducteur peut éventuellement être composé de plusieurs métaux comme par exemple une fine couche de Ti ou TiN et une couche de Cu.

Dans un procédé de soulèvement, des motifs sont formés par lithographie dans une résine photosensible. Un dépôt de métal non conforme est alors réalisé au-dessus de la résine et entre les motifs de résine. La résine est ensuite retirée (et avec elle le métal déposé à sa surface), ne laissant du métal que là où il avait été déposé entre les motifs de résine. Ce type de procédé sera préférentiellement utilisé pour des métaux contaminants et difficiles à graver tels que Ni, Pt, Au, Ag.

### Autres modes de réalisation

Il va de soi que le procédé 300 décrit précédemment peut être utilisé pour réaliser d'autres types de dispositifs spintroniques, que ce soit d'autres types de dispositifs mémoires comme des SOT-MRAMs, des MRAMs contrôlées en tension, des composants radiofréquence utilisant les phénomènes de STT ou SOT, voire des capteurs de champs magnétiques.

Par exemple, pour une SOT-MRAM, les zones conductrices 220 pourront être des lignes conductrices de type « interconnect » réalisées en métal lourd présentant un fort couplage spin orbite, par exemple en Ta, Pt ou W. Les piliers magnétiques 240 formant la majeure partie de la couche de stockage épaisse 255 de la cellule SOT-MRAM seront alors réalisés directement au-dessus de ces lignes conductrices 220.

[Fig. 14] La structure se présente alors sous la forme représentée sur la Figure 14. Les éléments mémoire sont alors des dispositifs à 3 terminaux comme il est bien connu pour les SOT-MRAMs. Bien entendu, plusieurs jonctions tunnels peuvent partager une même ligne comme il est bien connu dans les architectures de SOT-MRAMs.

Pour une PSA-STT-MRAM, les zones conductrices 220 pourront être remplacées par des vias. Les piliers magnétiques 240 formant la majeure partie de la couche de stockage épaisse 255 de la cellule PSA-STT-MRAM seront alors réalisés directement au-dessus de ces vias, leur axe vertical étant par exemple aligné avec le centre du via.

Dans le cas de composants radiofréquence (RF) à base de STT et de SOT, la structure globale du dispositif est similaire à celle des jonctions tunnel pour PSA-STT-MRAMs. Cependant, l'épaisseur H de la couche de stockage sera ajustée différemment par rapport à une mémoire car on cherchera pour un composant RF, par exemple de type oscillateur, non pas à avoir une stabilité thermique importante de l'aimantation (pouvant assurer une rétention de 10 ans par exemple) mais à permettre à l'aimantation de la couche épaisse de précesser sous l'effet du courant d'excitations. Automatiquement donc, le facteur de stabilité thermique du pilier magnétique 240 sera ici choisi plus faible que pour une mémoire. Ceci sera réalisé en ajustant de façon appropriée la hauteur H du pilier magnétique 240 par rapport à sa géométrie latérale comme il est connu de l'homme de l'art.

Pour la réalisation d'un capteur de champ magnétique, on cherchera à donner au pilier magnétique 240 formant la couche active sensible du capteur, une faible anisotropie effective, c'est-à-dire une anisotropie effective telle que le champ d'anisotropie magnétique effectif de cette couche soit de l'ordre de la dynamique de champ magnétique que l'on cherche à mesurer. Si on veut mesurer un champ perpendiculaire au substrat 210, on donnera au pilier 240 une anisotropie effective légèrement négative favorisant une orientation de l'aimantation dans le plan. Cette aimantation sera tirée hors du plan par le champ à mesurer. La couche de référence 253 aura son aimantation hors du plan. Si on cherche à mesurer un champ planaire, on donnera au pilier magnétique 240 une forme favorisant une anisotropie hors du plan des couches, la couche de référence 253 étant cette fois piégée dans la direction du plan parallèle à la direction du champ à mesurer.

## Revendications

1. Procédé de fabrication d'un dispositif spintronique (200) comportant au moins un espaceur non-magnétique, (254) une couche de référence (253) et une couche de stockage (255) comportant au moins un pilier magnétique (240) comprenant les étapes suivantes :
- Déposer au moins une couche sacrificielle (400) d'une épaisseur au moins égale à celle du pilier magnétique que l'on cherche à former sur un substrat (210) comportant au moins une zone conductrice (220) émergent à la surface du substrat ;
- Former au moins une cavité (500) évasée, traversant ladite couche sacrificielle (400), dont la base est en vis-à-vis de la surface de ladite zone conductrice du substrat ;
- Déposer au moins une couche magnétique (600) dans ladite cavité d'épaisseur au moins égale à celle du pilier magnétique que l'on cherche à former ;
- Supprimer l'excès de couche magnétique (600) en dehors de la cavité (500) et planariser la surface de ladite couche magnétique (600) pour atteindre l'épaisseur visée de pilier magnétique ;
- Retirer au moins une partie de la couche sacrificielle afin de former à partir de la couche magnétique restante, au moins un pilier magnétique (240) formant tout ou partie de la couche de stockage dudit dispositif spintronique ;
- Déposer au moins l'espaceur non-magnétique (254) et la couche de référence (253) de sorte que chaque pilier magnétique (240) soit surmonté d'un élément (250) comprenant au moins ledit espaceur non-magnétique (254) et ladite couche de référence (253)
- Remplir les espaces entre les piliers magnétiques (240) par un matériau diélectrique (270) ;
- Réaliser un polissage pour supprimer l'excès de matériau diélectrique (270) de remplissage déposé à l'étape précédente afin d'avoir accès à une surface supérieure de l'élément (250) surmontant chaque pilier (240)
- Former un contact électrique (251) à la surface de l'élément (250) surmontant chaque pilier magnétique (240).

2. Procédé de fabrication selon la revendication 1 **caractérisé en ce que** l'étape de dépôt d'au moins l'espaceur non-magnétique (254) et la couche de référence (253) est réalisée de sorte que chaque pilier magnétique soit en outre entouré de au moins ledit espaceur non-magnétique et ladite couche de référence et de sorte qu'il n'y ait pas de contact électrique entre ledit pilier magnétique (240) et au moins ledit espaceur non-magnétique et la couche de référence entourant ledit pilier.

3. Procédé de fabrication selon la revendication 1 **caractérisé en ce que** l'étape de formation des cavités (500) est réalisée avec une approche « damascène » ou « double-damascène ».

4. Procédé de fabrication selon l'une quelconque des revendications précédentes **caractérisé en ce que** les cavités (500) 2. réalisées lors de l'étape de formation des cavités ont une section à leur base plus petite qu'à leur sommet.

5. Procédé de fabrication selon l'une quelconque des revendications précédentes **caractérisé en ce que** ladite couche magnétique (600) est formée de plusieurs couches de matériaux magnétiques et non magnétiques, de telle sorte que la proportion de matériaux magnétiques par rapport aux matériaux non magnétiques soit suffisante pour que la capacité de l'aimantation de la couche de stockage à sortir du plan soit fortement augmentée voire que son anisotropie de forme devienne hors du plan.

6. Procédé de fabrication selon l'une quelconque des revendications précédentes **caractérisé en ce que** ladite couche magnétique (600) est formée majoritairement d'un matériau présentant un faible amortissement de Gilbert.

7. Procédé de fabrication selon l'une quelconque des revendications précédentes **caractérisé en ce que** le dispositif spintronique (200) est un point mémoire magnétique à accès aléatoire de type « perpendicular shape anisotropy spin-transfer torque » ou PSA-STT-MRAM.

8. Procédé de fabrication selon l'une quelconque des revendications 1 à 5 **caractérisé en ce que** le dispositif spintronique (200) est un point mémoire magnétique à accès aléatoire de type « perpendicular shape anisotropy spin-orbit torque » ou PSA-SOT-MRAM.

9. Procédé de fabrication selon l'une quelconque des revendications 1 à 5 **caractérisé en ce que** le dispositif spintronique (200) est un capteur de champ magnétique.

10. Procédé de fabrication selon l'une quelconque des revendications 1 à 5 **caractérisé en ce que** le dispositif spintronique (200) est un composant radiofréquence.

## Patentansprüche

1. Verfahren zur Herstellung einer spintronischen Vorrichtung (200) mit mindestens einem nichtmagnetischen Abstandshalter (254), einer Referenzschicht (253) und einer Speicherschicht (255) mit mindestens einem magnetischen Pfeiler (240), das die folgenden Schritte umfasst:
- Aufbringen mindestens einer Opferschicht (400) mit einer Dicke, die mindestens gleich der Dicke des magnetischen Pfeilers ist, der auf einem Substrat (210) gebildet werden soll, das mindestens eine leitende Zone (220) aufweist, die an der Oberfläche des Substrats zutage tritt;
- Bilden mindestens einer aufgeweiteten Ausnehmung (500), die die Opferschicht (400) durchdringt, und deren Basis der Oberfläche der leitfähigen Zone des Substrats gegenüberliegt;
- Aufbringen mindestens einer Magnetschicht (600) in der Ausnehmung, deren Tiefe mindestens gleich der Dicke des magnetischen Pfeilers ist, der gebildet werden soll;
- Entfernen des Überschusses der Magnetschicht (600) außerhalb der Ausnehmung (500) und Planarisieren der Oberfläche der Magnetschicht (600), um die für den magnetischen Pfeiler angestrebte Dicke zu erhalten;
- Beseitigen mindestens eines Teils der Opferschicht, um aus der verbleibenden Magnetschicht mindestens einen magnetischen Pfeiler (240) zu bilden, der die gesamte oder einen Teil der Speicherschicht der spintronischen Vorrichtung bildet;
- Aufbringen mindestens des nichtmagnetischen Abstandshalters (254) und der Referenzschicht (253), so dass jeder magnetische Pfeiler (240) von einem Element (250) überdeckt wird, das mindestens den nichtmagnetischen Abstandshalter (254) und die Referenzschicht (253) umfasst;
- Auffüllen der Zwischenräume zwischen den magnetischen Pfeilern (240) mit einem dielektrischen Material (270);
- Ausführen eines Polierprozesses um überschüssiges dielektrisches Füllmaterial (270) zu entfernen, das im vorherigen Schritt aufgebracht wurde, um Zugang zu einer oberen Oberfläche des Elements (250) zu erhalten, das jeden Pfeiler (240) überdeckt;
- Bilden eines elektrischen Kontakts (251) an der Oberfläche des Elements (250), das jeden magnetischen Pfeiler (240) überdeckt.

2. Herstellungsverfahren nach Anspruch 1, **dadurch gekennzeichnet, dass** der Schritt des Aufbringens mindestens des Abstandshalters (254) und der Referenzschicht (253) derart durchgeführt wird, dass jeder magnetische Pfeiler von mindestens dem nichtmagnetischen Abstandshalter und der Referenzschicht umgeben ist und dass es keinen elektrischen Kontakt zwischen dem magnetischen Pfeiler (240) und mindestens dem nichtmagnetischen Abstandshalter und der Referenzschicht gibt, die den Pfeiler umgibt.

3. Herstellungsverfahren nach Anspruch 1, **dadurch gekennzeichnet, dass** der Schritt des Bildens der Ausnehmungen (500) mittels eines "Single-" oder "Dual-Damascene-Prozesses" durchgeführt wird.

4. Herstellungsverfahren nach einem der vorherigen Ansprüche, **dadurch gekennzeichnet, dass** die im Schritt der Bildung der Ausnehmungen erzeugten Ausnehmungen (500) an ihrer Basis einen kleineren Querschnitt aufweisen als an ihrer Spitze.

5. Herstellungsverfahren nach einem der vorherigen Ansprüche, **dadurch gekennzeichnet, dass** die Magnetschicht (600) aus mehreren Schichten aus magnetischen und nichtmagnetischen Materialien gebildet wird, so dass das Verhältnis der magnetischen Materialien zu den nichtmagnetischen Materialien ausreichend ist, um die Kapazität der Magnetisierung der Speicherschicht aus der Ebene herauszutreten in hohem Grade erhöht wird oder sogar ihre Formanisotropie aus der Ebene heraustreten lässt.

6. Herstellungsverfahren nach einem der vorherigen Ansprüche, **dadurch gekennzeichnet, dass** die Magnetschicht (600) überwiegend aus einem Material mit geringer Gilbert-Dämpfung gebildet wird.

7. Herstellungsverfahren nach einem der vorherigen Ansprüche, **dadurch gekennzeichnet, dass** die spintronische Vorrichtung (200) ein magnetischer Direktzugriffsspeicher vom Typ "perpendicular shape anisotropy spin-transfer torque" oder PSA-STT-MRAM ist.

8. Herstellungsverfahren nach einem der Ansprüche 1 bis 5, **dadurch gekennzeichnet, dass** die spintronische Vorrichtung (200) ein magnetischer Direktzugriffsspeicher vom Typ "perpendicular shape anisotropy spin-orbit torque" oder PSA-SOT-M RAM ist.

9. Herstellungsverfahren nach einem der Ansprüche 1 bis 5, **dadurch gekennzeichnet, dass** die spintronische Vorrichtung (200) ein Magnetfeld-Sensor ist.

10. Herstellungsverfahren nach einem der Ansprüche 1 bis 5, **dadurch gekennzeichnet, dass** die spintronische Vorrichtung (200) eine Hochfrequenzkomponente ist.

## Claims

1. Method for manufacturing a spintronic device (200) comprising at least a non-magnetic spacer (254), a reference layer (253) and a storage layer (255) comprising at least one magnetic pillar (240) comprising the following steps:
- Depositing at least one sacrificial layer (400) of thickness at least equal to that of the magnetic pillar that it is desired to form on a substrate (210) comprising at least one conductive zone (220) emerging on the surface of the substrate;
- Forming at least one flared cavity (500), traversing said sacrificial layer (400), the base of which is facing the surface of said conductive zone of the substrate;
- Depositing at least one magnetic layer (600) in said cavity, of thickness at least equal to that of the magnetic pillar that it is desired to form;
- Eliminating the excess of magnetic layer (600) outside of the cavity and planarizing the surface of said magnetic layer (600) to reach the targeted magnetic pillar thickness;
- Removing at least a part of the sacrificial layer in order to form, from the remaining magnetic layer, at least one magnetic pillar (240) forming all or part of the storage layer of said spintronic device;
- Depositing at least the non-magnetic spacer (254) and the reference layer (253) such that each magnetic pillar (240) is surmounted by an element (250) comprising at least said non-magnetic spacer (254) and said reference layer (253);
- Filling the spaces between the magnetic pillars (240) with a dielectric material (270);
- Carrying out a polishing to eliminate the excess of dielectric filling (270) material deposited at the preceding step in order to have access to an upper surface of the element (250) surmounting each pillar (240);
- Forming an electrical contact (251) on the surface of the element (250) surmounting each magnetic pillar (240).

2. Manufacturing method according to claim 1 **characterised in that** the step of depositing at least the non-magnetic spacer (254) and the reference layer (253) is carried out such that each magnetic pillar is further surrounded by at least said non-magnetic spacer and said reference layer and such that there is no electrical contact between said magnetic pillar (240) and at least said non-magnetic spacer and the reference layer surrounding said pillar.

3. Manufacturing method according to claim 1 **characterised in that** the step of forming the cavities (500) is carried out with a "damascene" or "dual damascene" approach.

4. Manufacturing method according to any one of the preceding claims **characterised in that** the cavities (500) produced during the step of forming cavities have a section at their base smaller than at their top.

5. Manufacturing method according to any one of the preceding claims **characterised in that** said magnetic layer (600) is formed of several layers of magnetic and non-magnetic materials, in such a way that the proportion of magnetic materials compared to non-magnetic materials is sufficient so that the capacity of the magnetisation of the storage layer to come out of the plane is greatly increased or even that its shape anisotropy becomes out-of-plane.

6. Manufacturing method according to any one of the preceding claims **characterised in that** said magnetic layer (600) is mainly formed of a material having a low Gilbert damping.

7. Manufacturing method according to any one of the preceding claims **characterised in that** the spintronic device (200) is a perpendicular shape anisotropy spin transfer torque magnetic random access memory point or PSA-STT-MRAM.

8. Manufacturing method according to any one of claims 1 to 5 **characterised in that** the spintronic device (200) is a perpendicular shape anisotropy spin orbit torque magnetic random access memory point or PSA-SOT-MRAM.

9. Manufacturing method according to any one of claims 1 to 5 **characterised in that** the spintronic device (200) is a magnetic field sensor.

10. Manufacturing method according to any one of claims 1 to 5 **characterised in that** the spintronic device (200) is a radiofrequency component.
